**Europäisches Patentamt**

**European Patent Office**

**Office européen des brevets**

(19)

(11) Veröffentlichungsnummer: **0 183 916**
**B1**

# EUROPÄISCHE PATENTSCHRIFT

(12)

(45) Veröffentlichungstag der Patentschrift:
**19.04.89**

(21) Anmeldenummer: **85110058.6**

(22) Anmeldetag: **09.08.85**

(51) Int. Cl.⁴: **H 01 P 5/08,** H 01 L 23/56

(54) Kontaktierung einer auf einem Substrat angeordneten Mikrowellenschaltung.

(30) Priorität: **04.12.84 DE 3444076**

(43) Veröffentlichungstag der Anmeldung:
**11.06.86 Patentblatt 86/24**

(45) Bekanntmachung des Hinweises auf die Patenterteilung:
**19.04.89 Patentblatt 89/16**

(84) Benannte Vertragsstaaten:
**AT CH DE LI NL**

(56) Entgegenhaltungen:
**DE-A-2 456 367**
**US-A-4 042 952**
**US-A-4 242 157**
**US-A-4 326 180**

(73) Patentinhaber: **ANT Nachrichtentechnik GmbH,**
**Gerberstrasse 33, D-7150 Backnang (DE)**

(72) Erfinder: **Schiller, Wolfgang, Dipl.- Ing.,**
**Bismarckstrasse 22, D-7100 Heilbronn (DE)**

## Beschreibung

Die vorliegende Erfindung betrifft eine Vorrichtung zum Kontaktieren einer auf einem Substrat angeordneten Mikrowellenschaltung mit Steckeranschlüssen und/oder mit anderen Mikrowellenschaltungen auf benachbarten Substraten und masseseitig mit dem dss Substrat aufnehmenden Gehäuse, wobei das Substrat mit seiner Massefläche auf einem Metallrahmen elektrisch leitend befestigt ist.

Eine derartige Vorrichtung ist aus der DE-OS-2 456 367 bekannt. Hierbei bilden gefederte Druckelemente die Kontaktierung zwischen der auf dem Substrat aufgebrachten Mikrowellenschaltung und den Leiterbahnen und der Masseleitung einer Trägerplatte, worin das auf einen Metallrahmen befestigte Substrat eingesetzt ist.

Beim Einsatz von Keramiksubstraten in Metallgehäusen erfahren das Substrat und das Gehäuse bei Temperaturänderungen aufgrund der stark voneinander abweichenden Wärmeausdehnung von Keramik und Metall sehr unterschiedliche mechanische Ausdehnungen. Unter diesen Gegebenheiten bergen federnde Kontakte die Gefahr, daß an ihnen Störimpulse entstehen. Dagegen sind besonders digitale Signale störanfällig, weil die Störimpulse Phasensprünge erzeugen, die zu Verfälschungen einzelner Zeichen führen.

Der Erfindung liegt daher die Aufgabe zugrunde, eine Vorrichtung der eingangs genannten Art anzugeben, die eine sichere definierte Kontaktgabe gewährleistet, such wenn das Substrat und das Gehäuse sich verschieden stark ausdehnen.

Erfindungsgemäß wird diese Aufgabe dadurch gelöst, daß der Metallrahmen mit seitlich heraustehenden Zungen versehen ist, die mit dem Gehäuse verschraubt sind, und daß auf einigen Zungen Substrate aus flexiblem Material aufgebracht sind, die auf ihrer Oberseite planare Leitungsstücke tragen, welche über aufgelötete Drähtchen einerseits mit der Mikrowellenschaltung auf dem Substrat und andererseits mit planaren Leitungsstücken von benachbarten Substraten oder mit Leitungen von Steckeranschlüssen verbunden sind.

Die erfindungsgemäße Kontaktierung ermöglicht ein leichtes Austauschen des Substrats, weil im Gehäuse keine Lötungen auf dem Subtrat vorgenommen werden müssen. Wegen der ausgezeichneten Wärmeleitfähigkeit von Keramik müßte nämlich die Lötstelle auf dem Substrat erst vorgeheizt werden, damit das Lot überhaupt zerfließt. Das Vorheizen des Substrats im Gehäuse ist aber mit großem Aufwand verbunden.

Anhand eines in der Zeichnung dargestellten Ausführungsbeispiels wird nachfolgend die Erfindung näher erläutert. Es zeigen:

Fig. 1    eine perspektivische Darstellung eines Gehäuses mit darin kontaktierten Substraten und

Fig. 2    einen Metallrahmen für ein Substrat.

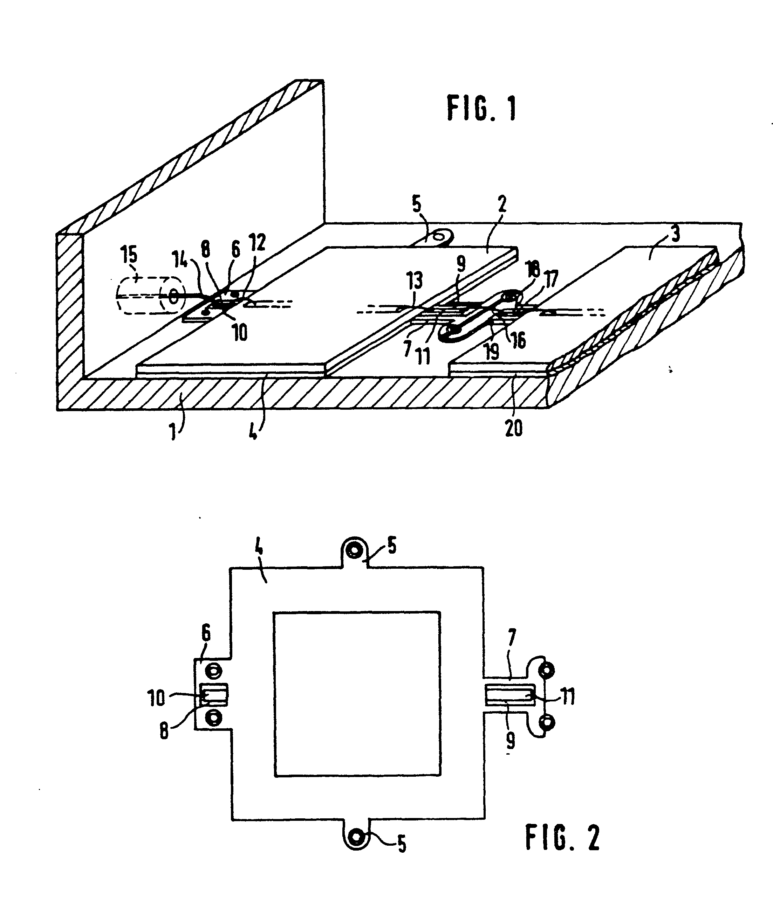

Aus der Figur 1 geht ein Ausschnitt eines Gehäuses 1 hervor, welches mehrere Keramiksubstrate 2 und 3 mit in der Zeichnung nicht dargestellten Mikrowellenschaltungen aufnimmt.

Die Keramiksubstrate 2, 3 sind einerseits mit ihrer an der Unterseite befindlichen Massefläche mit dem Gehäuse 1 und andererseits mit ihren auf der Oberseite verlaufenden planaren Leitungen mit planaren Leitungen auf Nachbarsubstraten und/oder Steckeranschlüssen zu kontaktieren.

Zur Herstellung dieser Kontakte dient ein Metallrahmen, auf dem das Substrat vor dem Einbau ins Gehäuse 1 mit seiner Massefläche aufgelötet wird. Die Draufsicht auf einen solchen Metallrahmen 4 zeigt die Fig. 2.

Der Metallrahmen 4 weist seitlich herausragende Zungen 5, 6 und 7 auf. Die Zungen 5, 6, 7 werden direkt mit dem Boden des Gehäuses 1 verschraubt, womit über den Metallrahmen die Kontaktierung zwischen der Massefläche des Substrats 2, und dem Gehäuse 1 erfolgt.

Auf den Zungen 6 und 7 sind außerdem Substrate sus einem flexiblen Material (z. B. Plastik) aufgebracht, deren Oberseite mit einem planaren Leitungsstück 10, 11 beschichtet ist.

Diese planaren Leitungsstücke 10, 11 sind über aufgelötete Drähtchen 12, 13 mit den planaren Leitungen auf dem Substrat verbunden. Die Kontaktierung der Drähtchen 12, 13 mit den planaren Leitungen auf dem Substrat 2 erfolgt ebenfalls durch Löten. Weil wegen der guten Wärmeleitfähigkeit des Keramiksubstrats ein Vorheizen der Lötstelle erforderlich ist, wird dieser Lötvorgang vor dem Einbau des Substrats in dss Gehäuse 1 vorgenommen.

Für Leitungen auf den planaren Leitungsstücken 10, 11, die auf den aus flexiblem Material hergestellten Substraten 8, 9 verlaufen, ist kein vorheizen nötig, da diese substrate eine wesentlich schlechtere Wärmeleitfähigkeit besitzen und dadurch das Lot auf den metallischen Leitungen besser zerfließen lassen. Aus diesem Grund kann der Innenleiter 14 eines koaxialen Steckeranschlusses 15 bzw. ein Verbindungsdrähtchen zum Nachbarsubstrat mit dem planaren Leitungsstück 10 auf der Zunge 6 bzw. mit dem planaren Leitungsstück 11 auf der Zunge 7 problemlos innerhalb des Gehäuses verlötet werden.

Das die Verbindung zwischen der Mikrowellenschaltung auf dem Substrat 2 und der Mikrowellenschaltung auf dem Nachbarsubstrat 3 herstellende Drähtchen 16 ist einerseits mit dem planaren Leitungsstück 11 des Substrats 11 auf der Zunge 7 des Metallrahmens 4 und andererseits mit dem planaren Leitungsstück 17 des Substrat 18 auf der Zunge 19 des das Nachbarsubstrat 3 tragenden Metallrahmens 20 verlötet. Die gleichgestalteten Zungen 7 und 19 der Metallrahmen 4 und 20 sind, wie Fig. 1 verdeutlicht, mit Schrauben, die an beiden Zungen 7, 19 gleichzeitig angreifen, am Boden des Gehäuses 1 verschraubt.

Die die Substrate 2, 3 tragende Metallrahmen und insbesondere deren seitlich herausstehenden Zungen besitzen nur eine geringe Materialstärke, so daß sie sehr flexibel sind, um unterschiedliche Ausdehnungen des Gehäuses und der Substrate auffangen können.

Mit dieser Erfindung ist also eine Vorrichtung geschaffen worden, die definierte Lötkontaktierungen selbst bei schwer lötbaren Keramiksubstraten zuläßt, die sich bei Tempertüränderungen gegenüber dem Metallgehäuse sehr unterschiedlich ausdehnen.

**Patentanspruch**

Auf einem Substrat angeordnete Mikrowellenschaltung, die mit Steckeranschlüssen und/oder mit anderen Mikrowellenschaltungen auf benachbarten Substraten und masseseitig mit dem das Substrat aufnehmenden Gehäuse verbunden ist, wobei das Substrat mit seiner Massefläche auf einem Metallrahmen elektrisch leitend befestigt ist, dadurch gekennzeichnet, daß der Metallrahmen (4, 20) mit seitlich herausstehenden Zungen (5, 6, 7, 19) versehen ist, die mit dem Gehäuse (1) verschraubt sind, und daß auf einigen Zungen (6, 7, 19) Substrste (8, 9, 18) aus flexiblem Material aufgebracht sind, die auf ihrer Oberseite planare Leitungsstücke (10, 11, 17) tragen, welche über aufgelötete Drähtchen (12, 13, 16) einerseits mit der Mikrowellenschaltung auf dem Substrat (2, 3) und andererseits mit planaren Leitungsstücken (17) von benachbarten Substraten (3) oder mit Leitungen (14) von Steckeranschlüssen (15) verbunden sind.

**Claim**

A microwave circuit disposed on a substrate, which circuit is connected to plug connections and/or other microwave circuits on adjacent substrates and is connected with respect to ground to a housing receiving the substrate, wherein the substrate is electrically conductively secured with its ground side to a metal frame, characterized in that the metal frame (4, 20) is provided with laterally protruding tongues (5, 6, 7, 19) that are screwed to the housing, and that attached to some of the tongues (6, 7, 19) are substrates (8, 9, 15) of flexible material on top of which are planar lead segments (10, 11, 17) that are connected both to the microwave circuit on the substrate (2, 3), via soldered-on wires (12, 13, 16), and to planar lead segments (17) of adjacent substrates (3) or to leads (14) of plug connections (15).

**Revendication**

Circuit a Micro-ondes disposé sur un substrat et relié à des contacts de connecteur et/ou à d'autres circuits à micro-ondes sur des substrats voisins, ainsi que, pour la mise à la masse, au boîtier recevant le substrat, le substrat étant fixé par sa surface de masse sur un cadre métallique par une liaison électriquement conductrice, caractérisé en ce que le cadre métallique (4, 20) est pourvu de languettes (5, 6, 7, 19) dépassant latéralement et qui sont fixées par vissage au boîtier (1), et que des substrats (8, 9, 18) en matériau souple sont appliqués sur quelques languettes (6, 7, 19), substrats portant sur leurs côtés supérieurs des segments de conducteurs plans (10, 11, 17) qui sont reliés par de petits fils métalliques soudés (12, 13, 16), d'une part au circuit à micro-ondes sur le substrat (2, 3) et d'autre part à des segments de conducteurs plans (17) de substrats (3) voisins ou à des conducteurs (14) raccordés à des contacts de connecteur (15).

FIG. 1

FIG. 2